(19) Europäisches Patentamt
European Patent Office
Office européen des brevets

(11) **EP 1 950 575 A2**

(12) **EUROPEAN PATENT APPLICATION**

(43) Date of publication:
**30.07.2008 Bulletin 2008/31**

(51) Int Cl.:
***G01R 27/18*** *(2006.01)*

(21) Application number: **08250073.7**

(22) Date of filing: **08.01.2008**

| | |
|---|---|
| (84) Designated Contracting States:<br>**AT BE BG CH CY CZ DE DK EE ES FI FR GB GR HR HU IE IS IT LI LT LU LV MC MT NL NO PL PT RO SE SI SK TR**<br>Designated Extension States:<br>**AL BA MK RS** | (72) Inventors:<br>• **Fisher, Steven Peter**<br>  **Newcastle upon Tyne NE7 7RX (GB)**<br>• **Barker, Anthony**<br>  **County Durham SR8 3JT (GB)**<br>• **Wallace, James Jackson Alexander**<br>  **Newcastle upon Tyne NE6 5XX (GB)** |
| (30) Priority: **23.01.2007 GB 0701200** | (74) Representative: **Vinsome, Rex Martin et al** |
| (71) Applicant: **Seaward Electronic Limited**<br>**18 Bracken Hill,**<br>**South West Industrial Estate Peterlee**<br>**County Durham, SR8 2SW (GB)** | **Urquhart-Dykes & Lord LLP**<br>**12th Floor**<br>**Cale Cross House**<br>**156 Pilgrim Street**<br>**Newcastle-upon-Tyne NE1 6SU (GB)** |

(54) **Method and apparatus for determining impedance of live-earth loop of electrical power supply**

(57)    A measuring apparatus (20) for determining impedance of a live-earth loop of an electrical power supply circuit having live, earth and neutral conductors is disclosed. The apparatus comprises first measuring means for determining values of voltage between live and neutral terminals of the circuit while a resistive load is connected between live and neutral terminals of the circuit and while no resistive load is connected between live and neutral terminals of the circuit. Second measuring means determines values of voltage between live and earth terminals of the circuit while a resistive load is connected between live and neutral terminals of the circuit and while no resistive load is connected between live and neutral terminals of the circuit. A current generator (26) applies a test current between the neutral and earth terminals such that the test current has sufficient magnitude but insufficient duration to activate a residual current device (RCD) circuit breaker connected between the live and neutral terminals. A third measuring means determines values of voltage and current between neutral and earth terminals of the circuit while the test current is applied. A processor (28) determines the impedance of a live-earth loop of the circuit by means of the values determined by said first, second and third measuring means.

Figure 1

EP 1 950 575 A2

**Description**

The present invention relates to a method and apparatus for determining the impedance of a live-earth loop of an electrical power supply, and relates particularly, but not exclusively, to a method and apparatus for determining the impedance of a live-earth loop of an electrical power supply containing a residual current device (RCD) circuit breaker.

EP 1306682 discloses a circuit tester for measuring the live-earth impedance of a mains power supply circuit including a residual current device (RCD) circuit breaker in which the neutral-earth loop resistance is determined by injecting a low DC current into the neutral-earth circuit and measuring the voltage change.

However, this arrangement suffers from the drawback that in order to avoid activating the RCD circuit breaker, the DC current is of such small magnitude that the measured voltage values suffer from an unfavourably small signal to noise ratio, which limits the accuracy of such measurements.

Preferred embodiments of the present invention seek to overcome the above disadvantages of the prior art.

According to an aspect of the present invention, there is provided a method of determining impedance of a live-earth loop of an electrical power supply circuit having live, earth and neutral conductors, the method comprising:

(i) determining values of voltage between live and neutral terminals of the circuit while a resistive load is connected between live and neutral terminals of the circuit and while no resistive load is connected between live and neutral terminals of the circuit;

(ii) determining values of voltage between live and earth terminals of the circuit while a resistive load is connected between live and neutral terminals of the circuit and while no resistive load is connected between live and neutral terminals of the circuit;

(iii) applying a test current between said neutral and earth terminals, wherein the test current has sufficient magnitude but insufficient duration to activate a residual current device (RCD) circuit breaker connected between said live and neutral terminals;

(iv) determining values of voltage and current between neutral and earth terminals of the circuit while said test current is applied; and

(v) determining the impedance of a live-earth loop of the circuit by means of the values determined in steps (i), (ii) and (iv).

By applying a test current between the neutral and earth terminals having sufficient magnitude but insufficient duration to activate a residual current device (RCD) circuit breaker connected between said live and neutral terminals, this provides the advantage of improving the signal to noise ratio of the measurements obtained.

The step of determining the impedance of said live-earth loop may further comprise:

(vi) determining the impedance of earth and neutral conductors of the circuit by means of the values determined in step (iv);

(vii) determining the impedance of a mains transformer and live conductor of the power supply by means of the values determined in step (ii);

(viii) determining the impedance of a neutral conductor of the power supply by means of the difference between the values determined in steps (i) and (ii); and

(ix) determining the impedance of said live-earth loop of the circuit summing values determined at steps (vii) and (viii).

The amplitude of the test current may be approximately 2A.

The duration of the test current may be approximately 50 $\mu$s.

The method may further comprise applying a plurality of test current pulses.

The frequency of said test current pulses may be between 15Hz and 50Hz.

The step of applying a test current may comprise discharging a capacitor connected in series with said neutral and earth conductors.

This provides the advantage that the test current can be supplied by the mains power supply circuit, which avoid excessive battery power consumption, which can be a significant disadvantage in the case of a battery powered portable apparatus.

The capacitor may be charged by said circuit during at least part of alternate first half cycles and may be discharged during at least part of alternate second half cycles.

According to another aspect of the present invention, there is provided a measuring apparatus for determining impedance of a live-earth loop of an electrical power supply circuit having live, earth and neutral conductors, the apparatus comprising:

(i) first measuring means for determining values of voltage between live and neutral terminals of the circuit while a resistive load is connected between live and neutral terminals of the circuit and while no resistive load is connected between live and neutral terminals of the circuit;

(ii) second measuring means for determining values of voltage between live and earth terminals of the circuit while a resistive load is connected between live and neutral terminals of the circuit and while no resistive load is connected between live and neutral terminals of the circuit;

(iii) current generating means for applying a test current between said neutral and earth terminals, wherein the test current has sufficient magnitude but insufficient duration to activate a residual current device (RCD) circuit breaker connected between said live and neutral terminals;

(iv) third measuring means for determining values of voltage and current between neutral and earth terminals of the circuit while said test current is applied; and

(v) calculating means for determining the impedance of a live-earth loop of the circuit by means of the values determined by said first, second and third measuring means.

The current generating means may comprise at least one capacitor and means for discharging at least one said capacitor when connected in series with said neutral and earth conductors.

The current generating means may be adapted to cause at least one said capacitor to be charged by said circuit during at least part of alternate first half cycles and to be discharged during at least part of alternate second half cycles.

A preferred embodiment of the invention will now be described, by way of example only and not in any limitative sense, with reference to the accompanying drawings, in which:-

Figure 1 shows an impedance measuring apparatus embodying the present invention connected to a mains electrical power supply for carrying out a first phase of a method embodying the present invention;

Figure 2 shows the apparatus of Figure 1 connected to the power supply of Figure 1 in order to carry out a second phase of the method; and

Figure 3 shows a current pulse generating circuit used in the apparatus of Figure 2.

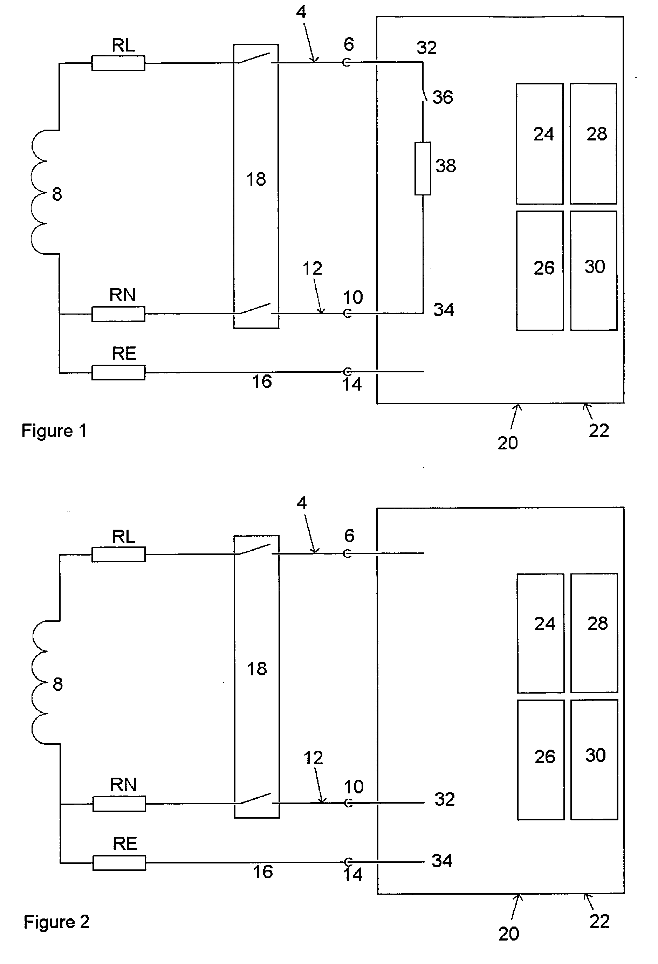

Referring to Figure 1, a mains power supply circuit has a live terminal 6 connected to a live conductor 4 having impedance $R_L$, a mains transformer 8, a neutral terminal 10 connected to a neutral conductor 12 having impedance $R_N$, and an earth terminal 14 connected to an earth conductor 16 having impedance $R_E$. A residual current device (RCD) circuit breaker 18 is connected between the live conductor 4 and the neutral conductor 12.

An impedance measuring apparatus 20 embodying the present invention has a housing 22 and includes a voltage-measuring device 24, a current generator 26, a processor 28, and a display 30, which may be any suitable display device familiar to persons skilled in the art, such as a liquid crystal display (LCD).

In order to determine the impedance of the live-earth loop of the power supply, for example in order to determine whether the correctly rated fuses are installed in the power supply circuit, the impedance measuring apparatus 20 is firstly connected by means of leads 32, 34 between the live and neutral terminals 6, 10 of the power supply circuit. The voltage drop between the live and neutral terminals 6, 10 is then determined for unloaded and loaded conditions, i.e. with switch 36 closed, allowing current to pass through a load resistor 38, or with the switch 36 open.

The difference between the loaded and unloaded measurements of $V_1$, the voltage between the live and neutral terminals 6, 10, indicates the voltage drop through the resistance $R_L$ of the live conductor 4, the mains transformer 8, and the resistance $R_N$ of the neutral conductor 12. The difference between the measured values of $V_2$, the voltage between the live and earth terminals 6, 14, when the load resistor 38 is connected between the live and neutral terminals 6, 10 and disconnected, indicates the voltage drop through the resistance $R_L$ of the live conductor 4, and the mains transformer 8.

Accordingly, by subtracting the difference in the measured values of $V_2$ when the resistor 38 is connected and disconnected from the difference between the loaded and unloaded measurements of $V_1$, the resistance $R_N$ of the neutral conductor 12 is then determined.

Referring now to Figure 2, in a second stage of the process of the present invention, the leads 32, 34 of the apparatus 20 are connected between the neutral and earth terminals 10, 14, and a test current of high magnitude (typically 2A) and short duration (typically 50 μs), is generated by current generator 26 and passed between the neutral and earth terminals 10, 14. The test current is in the form of a series of current pulses having separation between the pulses of approximately 60ms. The short duration of the current pulses prevents activation of the residual current device (RCD) circuit breaker 18, as a result of which a higher magnitude of test current can be used, which improves the signal to noise ratio of any measurements obtained. Also, by using a series of pulses, the effect of any noise is significantly reduced.

By measuring the test current and the voltage across the neutral-earth loop, the combined resistance of the neutral conductor 12 $R_N$ and the earth conductor 16 $R_E$ is determined by the apparatus 20. The loop impedance of the live-earth loop is then determined from

$$\text{Loop Impedance} = R_{NE} - R_N + R_L,$$

where $R_{NE}$ is the earth-neutral loop impedance.

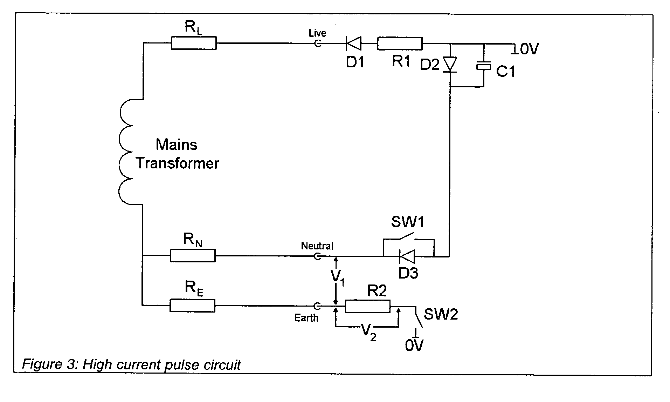

The current generator 26 of the apparatus is shown in more detail in Figure 3. Although it is possible to use the batteries to generate the high current pulse required for the neutral earth measurement, this is inefficient and can lead to a significantly reduced battery life. The arrangement of Figure 3 enables the generation of a high current test pulse which uses the mains voltage as the source. This involves charging a capacitor C1 on one half cycle and using the charge in the capacitor C1 to create the test current on the inverse half cycle.

When the high current test is required a solid state relay SW1 is closed on every negative half mains cycle. This enables capacitor C1 to charge to 22V on negative mains half cycles. An internal voltage monitor (not shown) is used to confirm that the capacitor C1 is charged. The charge in capacitor C1 is limited by a 22V zener diode D2. Relay SW1 is constantly switched throughout the duration of the test to maintain voltage charge in capacitor C1, and when the capacitor is fully charged then the test can be performed.

During the positive mains half cycle, at the peak of the mains cycle a FET SW2 is enabled for 50μs. The capacitor C1, which is charged to 22V, discharges through diode D3, the resistance $R_N$ of neutral conductor 12, the resistance $R_E$ of earth conductor 16, resistor R2 and FET SW2. Directly before the current pulse is applied $V_1$ is measured. This measures any residual voltage which may be present between the neutral and earth conductors 12, 16 and will be subtracted from the value of $V_1$ taken during the test pulse. During the 50 μs pulse both $V_1$ and $V_2$ are measured. $V_1$ measures the voltage drop directly across the $R_N$ and $R_E$ resistance while $V_2$ measures the drop across the known internal resistance and therefore the current flowing.

Voltage can be present on the Neutral conductor 12 (with reference to earth) due to parallel loads on the mains system. A diode D3 is used to stop any voltage, which is present on the neutral conductor (with reference to earth), flowing into the test circuit which will give inaccurate measurements. Relay SW1 is used to short-out the diode D3 on negative half cycles so that the capacitor Cl can be charged.

The resistance of $R_{NE}$ can be calculated by;

$$R_{NE} = R2 \ (V_1 - V_1 \text{offset})/V_2$$

where: $R_{NE}$ = Earth Neutral Resistance

$V_1$offset = Live The voltage measured across $R_{NE}$ with no test current flowing
$V_1$ = The voltage measured across $R_{NE}$ with the test current flowing
$V_2$ = The voltage measured across R2 which measures the test current flowing.

It will be appreciated by persons skilled in the art that the above embodiment has been described by way of example only, and not in any limitative sense, and that various alternations and modifications are possible without departure from the scope of the invention as defined by the appended claims.

**Claims**

1. A method of determining impedance of a live-earth loop of an electrical power supply circuit having live, earth and neutral conductors, the method comprising:

   (i) determining values of voltage between live and neutral terminals of the circuit while a resistive load is connected between live and neutral terminals of the circuit and while no resistive load is connected between live and neutral terminals of the circuit;
   (ii) determining values of voltage between live and earth terminals of the circuit while a resistive load is connected between live and neutral terminals of the circuit and while no resistive load is connected between live and neutral terminals of the circuit;

(iii) applying a test current between said neutral and earth terminals, wherein the test current has sufficient magnitude but insufficient duration to activate a residual current device (RCD) circuit breaker connected between said live and neutral terminals;
(iv) determining values of voltage and current between neutral and earth terminals of the circuit while said test current is applied; and
(v) determining the impedance of a live-earth loop of the circuit by means of the values determined in steps (i), (ii) and (iv).

2. A method according to claim 1, wherein the step of determining the impedance of said live-earth loop further comprises:

(vi) determining the impedance of earth and neutral conductors of the circuit by means of the values determined in step (iv);
(vii) determining the impedance of a mains transformer and live conductor of the power supply by means of the values determined in step (ii);
(viii) determining the impedance of a neutral conductor of the power supply by means of the difference between the values determined in steps (i) and (ii); and
(ix) determining the impedance of said live-earth loop of the circuit summing values determined at steps (vii) and (viii).

3. A method according to claim 1 or 2, wherein the amplitude of the test current is approximately 2A.

4. A method according to any one of the preceding claims, wherein the duration of the test current is approximately 50 $\mu$s.

5. A method according to any one of the preceding claims, further comprising applying a plurality of test current pulses.

6. A method according to claim 5, wherein the frequency of said test current pulses is between 15 and 50Hz.

7. A method according to any one of the preceding claims, wherein the step of applying a test current comprises discharging a capacitor connected in series with said neutral and earth conductors.

8. A method according to claim 7, wherein said capacitor is charged by said circuit during at least part of alternate first half cycles and is discharged during at least part of alternate second half cycles.

9. A method of determining impedance of a live-earth loop of an electrical power supply circuit having live, earth and neutral conductors, the method substantially as hereinbefore described with reference to the accompanying drawings.

10. A measuring apparatus for determining impedance of a live-earth loop of an electrical power supply circuit having live, earth and neutral conductors, the apparatus comprising:

(i) first measuring means for determining values of voltage between live and neutral terminals of the circuit while a resistive load is connected between live and neutral terminals of the circuit and while no resistive load is connected between live and neutral terminals of the circuit;
(ii) second measuring means for determining values of voltage between live and earth terminals of the circuit while a resistive load is connected between live and neutral terminals of the circuit and while no resistive load is connected between live and neutral terminals of the circuit;
(iii) current generating means for applying a test current between said neutral and earth terminals, wherein the test current has sufficient magnitude but insufficient duration to activate a residual current device (RCD) circuit breaker connected between said live and neutral terminals;
(iv) third measuring means for determining values of voltage and current between neutral and earth terminals of the circuit while said test current is applied; and
(v) calculating means for determining the impedance of a live-earth loop of the circuit by means of the values determined by said first, second and third measuring means.

11. An apparatus according to claim 10, wherein the current generating means comprises at least one capacitor and means for discharging at least one said capacitor when connected in series with said neutral and earth conductors.

12. An apparatus according to claim 11, wherein the current generating means is adapted to cause at least one said capacitor to be charged by said circuit during at least part of alternate first half cycles and to be discharged during at least part of alternate second half cycles.

Figure 1

Figure 2

Figure 3: High current pulse circuit

**EP 1 950 575 A2**

## REFERENCES CITED IN THE DESCRIPTION

### Patent documents cited in the description

- EP 1306682 A